# EUROPÄISCHE PATENTSCHRIFT

(11) **EP 0 362 492 B1**
(45) Veröffentlichungstag und Bekanntmachung des Hinweises auf die Patenterteilung: **25.08.1993**
(21) Anmeldenummer: 89112543.7
(22) Anmeldetag: 10.07.1989
(51) Int. Cl.: C04B 35/00, C04B 35/40, H01L 39/12

(54) **Verfahren zur Herstellung eines Hochtemperatursupraleiters sowie daraus bestehende Formkörper**
Process for producing high temperature superconductor and shaped product thereof
Procédé pour la production d'un matériel supraconducteur à température élevée et des articles à base de ce matériel

(30) Priorität: 03.09.1988 DE 3830092
(43) Veröffentlichungstag der Anmeldung: 11.04.1990
(73) Patentinhaber: HOECHST AKTIENGESELLSCHAFT, 65926 Frankfurt am Main (DE)
(72) Erfinder: Bock, Joachim, Dr., D-5042 Erftstadt (DE); Preisler, Eberhard, Dr., D-5042 Erftstadt (DE)

(56) Entgegenhaltungen:
- EP-A- 0 285 960
- APPLIED PHYSICS LETTERS, Band 53, Nr. 5, 1. August 1988, Seiten 423-425, New York, USA; D.G. HINKS et al.: "Preparation of Bi-Sr-Ca-Cu-O superconductors from oxide-glass precursors"
- JAPANESE JOURNAL OF APPLIED PHYSICS/PART 2: LETTERS, Band 27, Nr. 9, September 1988, Seiten L1696-L1698, Tokyo, Japan; Y. AKAMATSU et al.: "Instantaneous Preparation of Superconducting Thick Films through Melts in the Bi-Ca-Sr-Cu-O System"

## Beschreibung

Die vorliegende Erfindung betrifft ein Verfahren zur Herstellung eines Hochtemperatursupraleiters der Zusammensetzung Bi₂(Sr,Ca)₃Cu₂O₈₊ₓ, wobei das Verhältnis von Strontium zu Calcium (5 bis 2) : 1 beträgt und x einen Wert zwischen 0 und 2 hat sowie seine Anwendung zur Erzeugung von Formkörpern.

Durch die mit einem Nobelpreis ausgezeichnete Entdeckung von Bednorz und Müller ist bekannt, daß nicht nur gewisse Metallegierungen bei Temperaturen unter 24 K Supraleiter sind, sondern daß auch keramische Verbindungen, welche neben Kupferoxid Erdalkalioxide und Oxide der Seltenen Erden enthalten, supraleitende Eigenschaften aufweisen, und das schon bei höheren Temperaturen. Wegen ihrer höheren sog. Sprungtemperatur bezeichnet man diese Verbindungen als Hochtemperatursupraleiter.

Aus dem System Bismut-Strontium-Calcium-Kupfer-Sauerstoff sind bis jetzt drei Verbindungen bekannt, die Supraleitung aufweisen; und zwar
Bi₂(Sr,Ca)₂CuO₆₊ₓ("1-Schichtverbindung");
Sprungtemperatur: ca. 40 K;
Bi₂(Sr,Ca)₃Cu₂O₈₊ₓ("2-Schichtverbindung");
Sprungtemperatur: 85 K;
Bi₂(Sr,Ca)₄Cu₃O₁₀₊ₓ("3-Schichtverbindung");
Sprungtemperatur: ca. 105 K.

Dabei lassen sich die beiden zuerst genannten Verbindungen aus pulverförmigen Oxiden oder Carbonaten durch Sinterung herstellen, wobei in Falle der entsprechenden Einsatzmengen nur dann große Anteile der 2-Schichtverbindung im Phasengemisch erhalten werden, wenn die Sinterung knapp unterhalb des Schmelzpunktes der Pulvermischung durchgeführt wird. Um dabei ein Aufschmelzen von Teilen der Pulvermischung zu verhindern, wird die Pulvermischung zunächst bei niedriger Temperatur gesintert, um dann nach mehreren Zwischenmahlungen stets bei etwas erhöhter Temperatur erneut gesintert zu werden.

Weiterhin ist vorgeschlagen worden, Gemische aus den Oxiden des Bismuts, Strontiums, Calciums und Kupfers mit einem Überschuß an Kupferoxid aufzuschmelzen und aus dieser Schmelze Einkristalle insbesondere der 2-Schichtverbindung zu ziehen (vergleiche H.G. von Schnering et al. in: "Angewandte Chemie", 100 (1988) 604-607).

Schließlich werden zur Herstellung von supraleitendem Material mit einem stöchiometrischen Verhältnis der Oxide des Bismuts, Strontiums, Calciums und Kupfers von 2 : 2 : 2 : 3 Bi₂O₃, SrCO₃, CaCO₃ und CuO in einer mit Achat ausgekleideten Kugelmühle naß gemahlen. Die Mischung wird zur Zersetzung der Carbonate in Luft bei 830 °C calciniert und das calcinierte Material in einem Platintiegel aufgeschmolzen. Die Schmelze wird auf eine etwa 200 °C heiße Kupferfläche gegossen und dabei unter Bildung glasiger Teilchen mit geringem Durchmesser und einer Dicke von weniger als 0,3 mm abgeschreckt. Anschließend werden die glasigen Teilchen in Luft oder strömendem Sauerstoff bei 830 °C unter Bildung eines aus mindestens zwei Phasen bestehenden supraleitenden Materials getempert (vergl. HINKS et al.: "Preparation of Bi-Sr-Ca-Cu-O Superconductors from Oxide-Glass Precusors" in: APPLIED PHYSICS LETTERS, Band 53, August 1988, Nr. 5, Seiten 423 bis 425).

Nachteilig ist bei der zuerst genannten Arbeitsweise, daß sie technisch sehr aufwendig ist. Darüber hinaus liefern alle drei Arbeitsweisen keine röntgenographisch phasenreinen Produkte.

Es ist daher Aufgabe der vorliegenden Erfindung, ein Verfahren zur Herstellung eines Hochtemperatursupraleiters der Zusammensetzung Bi₂(Sr,Ca)₃Cu₂O₈₊ₓ ("2-Schichtverbindung") anzugeben, mit welchem bei geringem technischem Aufwand ein weitgehend phasenreines Produkt erhalten wird. Das wird erfindungsgemäß dadurch erreicht, daß man die Oxide und/oder Carbonate des Bismuts, Strontiums, Calciums und Kupfers in stöchiometrischem Verhältnis intensiv mischt; daß man die Mischung solange auf Temperaturen von 870 bis 1100 °C, vorzugsweise 950 bis 1000 °C, erhitzt, bis eine homogene Schmelze vorliegt; daß man die Schmelze in Kokillen vergießt und darin erstarren läßt; daß man die aus den Kokillen entnommenen Gußkörper 6 bis 30 Stunden, vorzugsweise 7 bis 12 Stunden, bei 780 bis 850 °C tempert;
und daß man die getemperten Gußkörper mindestens 6 Stunden bei Temperaturen von 600 bis 830°C in Sauerstoffatmosphäre behandelt.

Das Verfahren gemäß der Erfindung kann weiterhin wahlweise auch noch dadurch ausgestaltet sein, daß
a) man aus Kupfer bestehende Kokillen verwendet,
b) man bei 810 bis 830°C tempert,
c) man 8 bis 24 Stunden in Sauerstoffatmosphäre behandelt,
d) man bei Temperaturen von 800 bis 820°C in Sauerstoffatmosphäre behandelt,
e) man die Gußkörper vor ihrer Temperung durch mechanische Verfahren in Formkörper gewünschter Abmessungen überführt,
f) die Formkörper eine maximale Dicke bis zu 6 mm aufweisen
Schließlich können nach dem erfindungsgemäße Verfahren Formkörper hergestellt werden. Dabei kann ihre Form und Abmessung durch die Gestalt und dimensionierung der bei der Herstellung der Gußkörper verwendeten Kokillen bestimmt werden.

Beim Verfahren gemäß der Erfindung werden vorteilhafterweise Kupferkokillen verwendet, weil das in ihrer Oberfläche entstehende Kupferoxid systemimmanent ist und daher wenig oder gar nicht stören sollte.

Beim erfindungsgemäßen Verfahren bringt die Glühung in reinem Sauerstoff nur noch geringfügige, jedoch erkennbare Strukturänderungen mit sich. Zur Bildung dar reinen 2-Schichtverbindung ist das Glühen in Sauerstoff unerläßlich.

Der Sauerstoffindex der Bismut-Strontium-Calcium-Cuprate entspricht in der Regel nicht exakt dem Wert, der sich aus der Berechnung ergibt, wenn man die beteiligten Elemente jeweils in ihrer stabilsten Wertigkeitsstufe einsetzen würde. Ein Teil des Kupfers und/oder des Bismuts kann auch höherwertig sein. Die drei genannten Verbindungen weisen in ihrer Struktur Gitterplätze auf, die von Sauerstoff besetzt sein können, aber nicht besetzt sein müssen. In Abhängigkeit von der Höhe der Temperatur und des Sauerstoffpartialdruckes kann Sauerstoff in die Verbindungen eintreten oder auch aus ihnen wieder abgespalten werden. Die Angabe für den Sauerstoffindex a + x ist so gewählt, daß a dem Wert für die stabilste Wertigkeit (Cu: 2+, Bi: 3+, Sr: 2+, Ca: 2+) entspricht, während x die Sauerstoffäquivalente für den höherwertigen Anteil des Kupfers und Bismuts angibt.

### Beispiel 1 (Vergleichsbeispiel)

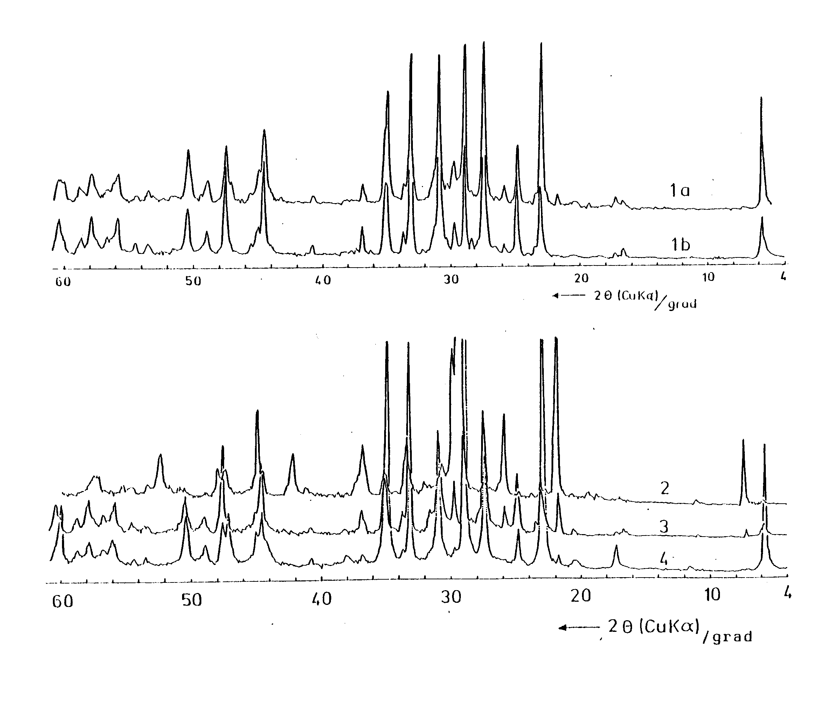

Eine Mischung aus 467 g SrO, 126 g CaO und 358 g CuO wurde in einem Intensivmischer homogenisiert, bevor sie in einem Sinterkorund-Tiegel 12 Stunden auf 920°C erhitzt wurde. Anschließend wurden der Mischung 1049 g Bi₂O₃ zugefügt. Die eine Hälfte der Vierkomponenten-Mischung wurde zunächst 12 Stunden bei 800°C getempert. Nach einer Zwischenmahlung wurde 6 Stunden auf 870°C erhitzt. Das erhaltene Produkt lieferte das Röntgendiagramm 1 a (vergleiche die Figur).
Die andere Hälfte der Vierkomponenten-Mischung wurde jeweils 12 Stunden bei 800, 820, 850, 860 und 870°C getempert, wobei nach jeder Temperaturbehandlung eine Zwischenmahlung erfolgte. Das erhaltene Produkt lieferte das Röntgendiagramm 1 b (vergleiche die Figur).
Ein Vergleich beider Röntgendiagramme zeigt einerseits, daß durch die längere Wärmebehandlung die 1-Schichtverbindung zugunsten der 2-Schichtverbindung abgereichert wird, aber andererseits die phasenreine 2-Schichtverbindung auch nach Temperzeiten von 72 Stunden noch nicht vorliegt. Das Produkt mit dem Röntgendiagramm 1 b wurde 8 Stunden in Sauerstoffatmosphäre auf 815°C erhitzt; seine Sprungtemperatur betrug dann 68 K.

### Beispiel 2 (Vergleichsbeispiel)

Eine Mischung aus 467 g SrO, 126 g CaO, 358 g CuO und 1049 g Bi₂O₃ wurde in einem Intensivmischer homogenisiert. 300 g dieser Mischung wurden in einen Sinterkorund-Tiegel gefüllt und dann 1 Stunde in einem Kammerofen auf 1000°C erhitzt. Die resultierende homogene Schmelze wurde in eine Kupferkokille (Abmessungen: 30 x 30 x 60 mm) vergossen und zur Erstarrung gebracht. Der Gußkörper wurde nach dem Abkühlen vermahlen. Das erhaltene Pulver lieferte das Röntgendiagramm 2 (vergleiche die Figur); es finden sich darin keine Reflexe der 2-Schichtverbindung, sondern nur solche der 1-Schichtverbindung und mindestens einer weiteren Phase.

Das Pulver mit dem Röntgendiagramm 2 wurde dreimal 8 Stunden bei 815°C an der Luft getempert, wobei es jeweils zwischen den Temperungen gemahlen wurde; schließlich wurde es noch einmal 8 Stunden bei 815°C unter Sauerstoff geglüht. Das Pulver lieferte nunmehr das Röntgendiagramm 3 (vergleiche die Figur), d.h. das Pulver war ein Phasengemisch aus der 1-Schichtverbindung und der 2-Schichtverbindung.

### Beispiel 3 (gemäß der Erfindung)

Die gemäß Beispiel 2 erzeugten Gußkörper wurden mit Hilfe einer Trennscheibe (mit Diamant belegte Kupferscheibe) in 3 mm dicke Platten zerlegt. Die Platten wurden 8 Stunden bei 815°C an der Luft getempert, wonach ausweislich des Röntgendiagrammes die 2-Schichtverbindung neben einem kleinen Rest von 1-Schichtverbindung vorlag. Bei der anschließenden 8stündigen Glühung der Platten bei 815°C in Sauerstoffatmosphäre verschwanden die Linien der 1-Schichtverbindung weitestgehend (vergleiche die Figur: Röntgendiagramm 4).
Die Sprungtemperatur der Platten betrug nunmehr 85 K.

### Beispiel 4 (gemäß der Erfindung)

Beispiel 3 wurde mit der Änderung wiederholt, daß die 3 mm dicken Platten 30 Stunden bei 790°C an der Luft getempert und anschließend 12 Stunden bei der gleichen Temperatur in Sauerstoffatmosphäre geglüht wurden.
Die Platten waren bezüglich ihres Röntgendiagrammes und ihrer Sprungtemperatur mit den nach Beispiel 3 erhaltenen Platten identisch.

## Patentansprüche

1. Verfahren zur Herstellung eines Hochtemperatursupraleiters der Zusammensetzung Bi₂(Sr,Ca)₃Cu₂O₈₊ₓ, wobei das Verhältnis von Strontium zu Calcium (5 bis 2) : 1 beträgt und x einen Wert zwischen O und 2 hat, dadurch gekennzeichnet, daß man die Oxide und/oder Carbonate des Bismuts, Strontiums, Calciums und Kupfers in stöchiometrischem Verhältnis intensiv mischt; daß man die Mischung solange auf Temperaturen von 870 bis 1100°C, vorzugsweise 950 bis 1000°C, erhitzt, bis eine homogene Schmelze vorliegt; daß man die Schmelze in Kokillen vergießt und darin erstarren läßt; daß man die aus den Kokillen entnommenen Gußkörper 6 bis 30 Stunden, vorzugsweise 7 bis 12 Stunden, bei 780 bis 850°C tempert; und daß man die getemperten Gußkörper mindestens 6 Stunden bei Temperaturen von 600 bis 830°C in Sauerstoffatmosphäre behandelt.

2. Verfahren nach Anspruch 1, dadurch gekennzeichnet, daß man aus Kupfer bestehende Kokillen verwendet.

3. Verfahren nach Anspruch 1 oder 2, dadurch gekennzeichnet, daß man bei 810 bis 830°C tempert.

4. Verfahren nach mindestens einem der Ansprüche 1 bis 3, dadurch gekennzeichnet, daß man 8 bis 24 Stunden in Sauerstoffatmosphäre behandelt.

5. Verfahren nach mindestens einem der Ansprüche 1 bis 4, dadurch gekennzeichnet, daß man bei Temperaturen von 800 bis 820°C in Sauerstoffatmosphäre behandelt.

6. Verfahren nach mindestens einem der Ansprüche 1 bis 5, dadurch gekennzeichnet, daß man die Gußkörper vor ihrer Temperung durch mechanische Verfahren in Formkörper gewünschter Abmessungen überführt.

7. Verfahren nach Anspruch 6, dadurch gekennzeichnet, daß die Formkörper eine maximale Dicke bis zu 6 mm aufweisen.

8. Formkörper, hergestellt nach dem Verfahren gemäß mindestens einem der Ansprüche 1 bis 7.

9. Formkörper, hergestellt nach dem Verfahren gemäß mindestens einem der Ansprüche 1 bis 5, dadurch gekennzeichnet, daß ihre Form und Abmessung durch die Gestalt und Dimensionierung der bei der Herstellung der Gußkörper verwendeten Kokillen bestimmt ist.

## Claims

1. A process for producing a high-temperature superconductor of the composition Bi₂(Sr,Ca)₃Cu₂O₈₊ₓ, the ratio of strontium to calcium being (5 to 2) : 1 and x having a value between 0 and 2, which comprises vigorously mixing the oxides and/or carbonates of bismuth, strontium, calcium and copper in a stoichiometric ratio, heating the mixture at temperatures of 870 to 1100°C, preferably 950 to 1000°C, until a homogeneous melt is obtained, casting the melt in molds and allowing it to solidify in them, annealing the cast bodies removed from the molds for 6 to 30 hours, preferably 7 to 12 hours, at 780 to 850°C, and treating the annealed cast bodies for at least 6 hours at temperatures from 600 to 830°C in an oxygen atmosphere.

2. The process as claimed in claim 1, wherein molds composed of copper are used.

3. The process as claimed in claim 1 or 2, wherein annealing is carried out at 810 to 830°C.

4. The process as claimed in at least one of claims 1 to 3, wherein treatment in an oxygen atmosphere is carried out for 8 to 24 hours.

5. The process as claimed in at least one of claims 1 to 4, wherein treatment in an oxygen atmosphere is carried out at tempera- tures from 800 to 820°C.

6. The process as claimed in at least one of claims 1 to 5, wherein the cast bodies are converted into shaped bodies of the desired sizes by mechanical processes before they are annealed.

7. The process as claimed in claim 6, wherein the shaped bodies have a maximum thickness of up to 6 mm.

8. Shaped bodies produced by the process as claimed in at least one of claims 1 to 7.

9. Shaped bodies produced by the process as claimed in at least one of claims 1 to 5, wherein their shape and size are determined by the shape and dimensioning of the molds used in producing the cast bodies.

## Revendications

1. Procédé de production d'un supraconducteur à haute température, de composition Bi₂(Sr,Ca)₃Cu₂O₈₊ₓ, le rapport du strontium au calcium étant de (5 à 2) : 1 et x ayant une valeur comprise entre 0 et 2, caractérisé en ce qu'on mélange intensément les oxydes et/ou carbonates de bismuth, de strontium, de calcium et de cuivre dans un rapport stoechiométrique ; qu'on chauffe le mélange à des températures comprises entre 870 et 1 100°C, de préférence entre 950 et 1 000°C, jusqu'à l'obtention d'une masse fondue homogène ; qu'on coule la masse fondue dans des coquilles et qu'on l'y laisse se solidifier ; qu'on trempe les corps coulés démoulés pendant 6 à 30 h, de préférence pendant 7 à 12 h, entre 780 et 850°C ; et qu'on traite les corps coulés trempés pendant au moins 6 h à des températures comprises entre 600 et 830°C, dans une atmosphère d'oxygène.

2. Procédé selon la revendication 1, caractérisé en ce qu'on utilise des coquilles en cuivre.

3. Procédé selon la revendication 1 ou 2, caractérisé en ce qu'on procède à la trempe entre 810 et 830°C.

4. Procédé selon au moins une des revendications 1 à 3, caractérisé en ce qu'on traite pendant 8 à 24 h dans une atmosphère d'oxygène.

5. Procédé selon au moins une des revendications 1 à 4, caractérisé en ce qu'on traite à des températures comprises entre 800 et 820°C, dans une atmosphère d'oxygène.

6. Procédé selon au moins une des revendications 1 à 5, caractérisé en ce qu'on transforme les corps coulés, avant la trempe, par des procédés mécaniques, en corps façonnés ayant les dimensions souhaitées.

7. Procédé selon la revendication 6, caractérisé en ce que les corps façonnés présentent une épaisseur maximale de 6 mm.

8. Corps façonnés, fabriqués selon le procédé selon au moins une des revendications 1 à 7.

9. Corps façonnés, fabriqués selon le procédé selon au moins une des revendications 1 à 5, caractérisés en ce que leur forme et leurs dimensions sont déterminées par la configuration et le dimensionnement des coquilles utilisées pour la fabrication des corps coulés.
